# EUROPÄISCHE PATENTSCHRIFT

(11) **EP 1 070 445 B1**
(45) Veröffentlichungstag und Bekanntmachung des Hinweises auf die Patenterteilung: **15.01.2003**
(21) Anmeldenummer: 99919091.1
(22) Anmeldetag: 16.03.1999
(51) Int. Cl.: H05K 3/36

(54) **HYBRIDSCHALTUNG MIT ANSCHLUSSFLÄCHEN (LOTPADS)**
HYBRID CIRCUIT WITH CONTACT SURFACES (SOLDER PADS)
CIRCUIT HYBRIDE DOTE DE PLAGES DE CONTACT

(30) Priorität: 31.03.1998 DE 19814429
(43) Veröffentlichungstag der Anmeldung: 24.01.2001
(73) Patentinhaber: TYCO Electronics Logistics AG, 9323 Steinach (CH)
(72) Erfinder: REHNELT, Karl, D-81249 München (DE); TEMPLIN, Frank, D-10367 Berlin (DE)
(74) Vertreter: Hirsch, Peter, Dipl.-Ing.
(86) Internationale Anmeldenummer: DE9900736
(87) Internationale Veröffentlichungsnummer: WO99051070

(56) Entgegenhaltungen:
- EP-A- 0 148 461

## Beschreibung

Die Erfindung betrifft eine Hybridschaltung mit einem senkrecht auf einer Mutterplatine montierbaren plattenförmigen keramischen Schaltungsträger, auf dem nahe einer Unterkante eine Reihe von Anschlußflächen (Lotpads) zur Kontaktierung der Schaltung mit Anschlüssen der Mutterplatine vorgesehen sind.

Die Montage insbesondere von Single-In-Line-Hybridbaugruppen auf einer Mutterplatine (Substrat) erfolgt heute oft noch mittels Durchsteckmontage, auch wenn die Hybridschaltung selbst oder ihre Umgebung auf der Mutterplatine ansonsten in der bekannten SMD-Technik ausgeführt sind. Zur Kontaktierung auf der Leiterplatte werden die Hybridschaltungen dabei meist mit einem auf die Stirnseite (also auf die beiden Unterkanten des Schaltungsträgers) aufgeschobenen sogenannten Anschlußkamm versehen. Dieser besteht zur Hybridschaltung hin meist aus taschenförmigen Anschlußklemmen, die, meist auf einer Seite, auf einem Lotpad anliegen und mit diesem verlötet werden, vgl. EP 0 148 461 A1. Leiterplattenseitig sind diese Anschlußklemmen bzw. Anschlußpins für die Durchsteckmontage beispielsweise mit einer V-förmigen Spitze ausgestaltet.

Bei hoher Pindichte des Anschlußkamms treten häufig Probleme wegen zu geringer Padabmessungen und damit verbundenem zu geringem Lotangebot auf.

Der vorliegen Erfindung liegt die Aufgabe zugrunde, hier Abhilfe zu schaffen, ohne die Montage aufwendiger zu gestalten.

Diese Aufgabe wird bei einer Hybridschaltung der eingangs angegebenen Art dadurch gelöst, daß die Anschlußflächen jeweils bis zur Unterkante herunterreichen, und daß jeweils eine durch den Schaltungsträger hindurchgehende, sich von der unteren Stirnfläche des Schaltungsträgers nach oben in die jeweilige Anschlußfläche erstreckende Ausnehmung vorgesehen ist, die ein Lotdepot bildet.

In Ausgestaltung der Erfindung können längliche Anschlußklemmen vorgesehen sein, deren eines Ende mit einer Kontaktstelle der Mutterplatine verbindbar ist und deren gegenüberliegendes Ende über eine taschenförmige, um die Unterkanten des Schaltungsträgers herumreichende Klemmkontur mit mindestens einer Anschlußfläche verlötet ist.

Die Erfindung wird im folgenden insbesondere anhand eines in den beiden Figuren der Zeichnung dargestellten Ausführungsbeispiels erläutert.

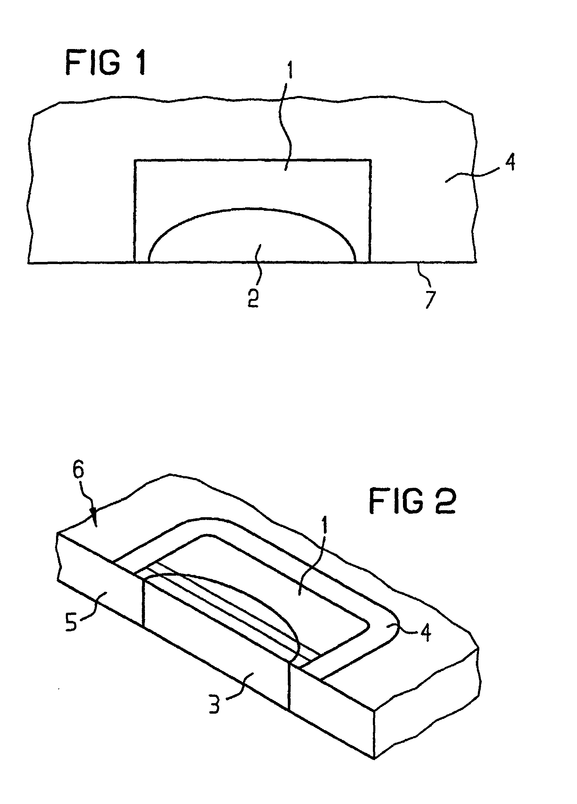

- Figur 1 und 2: zeigen in Seitenansicht bzw. in perspektivischer Draufsicht einen Schaltungsträger mit jeweils einem Lotpad und erfindungsgemäß ausgestaltetem Lotdepot, jedoch ohne Anschlußklemmen.

Die Qualität der am jeweiligen Lotpad herzustellenden Lötstelle hängt wesentlich vom Lotangebot ab, das dort zur Verbindung des Lotpads und der Anschlußklemme deponiert wird. Üblicherweise wird das Lotangebot in Fort vom Lotpaste mehr oder weniger auf die gesamte Fläche des Lotpads beispielsweise mittels Siebdruck aufgebracht. Die Lotpastenmenge insgesamt ist dann einerseits durch die Fläche des Lotpads, die bei hoher Pindichte tendenziell eher verringert werden soll, und andererseits, grundsätzlicher, durch die im wesentlichen flächige Aufbringung in Form einer relativ dünnen Schicht (ca. 100 um) begrenzt.

Erfindungsgemäß wird ein Teil des flächigen Lotangebots auf dem Lotpad 1 durch ein dreidimensionales Lotdepot 3 im Schaltungsträger 4, der zu diesem Zweck mit einer Ausnehmung 2 versehen wurde, ersetzt. Da, wie in Figur 1 und 2 erkennbar, die Ausnehmung 2 und damit auch das Lotdepot 3 bis zur unteren Stirnfläche des Schaltungsträgers 4 (Dicke: ca. 1 mm) reichen, wird erfindungsgemäß nicht nur ein Depotraum 2 für das Lot erzeugt, sondern die Anschlußfläche 1 wird im Ergebnis um die Unterkante 6 des Schaltungsträgers 4 gezogen. Durch diese Maßnahme wird für die Anschlußkämme ausreichend Lot an der Kontaktstelle bereitgestellt, um eine qualitativ hochwertige Lötung zu erzielen.

Die Erfindung kann in verschiedenen Abwandlungen realisiert werden. Die Anschlußpads 1 können einseitig auf dem Schaltungsträger 4 ausgeführt sein, oder auch gegenüberliegend, so daß beide Arme einer Kontaktklemme mit den jeweils gegenüberliegenden Anschlußpads verlötbar sind. Oberhalb des Lotdepots 3 können im Lotpad 1 auch die an sich bekannten Durchkontaktierungslöcher vorgesehen sein. Die Lotpads 1 können beispielsweise auch einseitig erfindungsgemäß mit Lotdepot 3 und auf der gegenüberliegenden Seite vollflächig ausgeführt sein. Die zusätzliche Bereitstellung von Lot durch das Lotdepot 3 ist von Vorteil bei den heute meist üblichen Lotprozessen, bei denen Lotpads und/oder der Anschlußkamm bereits vorab mit Lotpaste versehen sind, aber auch bei einem konventionellen Tauchlötprozeß.

Die Durchbrechung bzw. Bohrung durch das Material des Schaltungsträgers erfolgt, vgl. Figur 1, auf der Ritzspur der zunächst im Nutzen gefertigten Schaltungen.

## Patentansprüche

1. Hybridschaltung mit einem senkrecht auf einer Mutterplatine montierbaren plattenförmigen keramischen Schaltungsträger (4), auf dem nahe einer Unterkante (6) eine Reihe von Anschlußflächen (1) (Lotpads) zur Kontaktierung der Schaltung mit Anschlüssen der Mutterplatine vorgesehen sind,
**dadurch gekennzeichnet,**
**daß** die Anschlußflächen (1) jeweils bis zur Unterkante (6) herunterreichen, und daß jeweils eine durch den Schaltungsträger (4) hindurchgehende, sich von der unteren Stirnfläche (5) des Schaltungsträgers (4) nach oben in die jeweilige Anschlußflache (1) erstreckende Ausnehmung (2) vorgesehen ist, die ein Lotdepot (3) bildet.

2. Hybridschaltung nach Anspruch 1,
**dadurch gekennzeichnet,**
**daß** längliche Anschlußklemmen vorgesehen sind, deren eines Ende mit einer Kontaktstelle der Mutterplatine verbindbar ist und deren gegenüberliegendes Ende über eine taschenförmige, um die Unterkanten (6) des Schaltungsträgers (4) herumreichende Klemmkontur mit einer Anschlußfläche (1) verlötet ist.

## Claims

1. A hybrid circuit having a plate-shaped, ceramic circuit carrier (4) mountable perpendicularly on a mother board, on which circuit carrier (4) there are provided in the vicinity of a lower edge (6) a series of terminal areas (1) (solder pads) for making contact between the circuit and terminals on the mother board,
**characterised in that** the terminal areas (1) each extend down as far as the lower edge (6), and **in that** in each case a recess (2) is provided which passes through the circuit carrier (4), extends from the lower end face (5) of the circuit carrier (4) upwards into the respective terminal area (1) and forms a solder reservoir (3).

2. A hybrid circuit according to claim 1,
**characterised in that** elongate terminal lugs are provided, the one end of which may be connected with a contact point on the mother board, and the opposite end of which is soldered via a pocket-like terminal contour extending around the lower edges (6) of the circuit carrier (4) to a terminal area (1).

## Revendications

1. Circuit hybride comportant un support de circuit céramique en forme de plaque (4) pouvant être monté perpendiculairement sur une platine-mère, comportant près d'un bord inférieur (6) une série de surfaces de raccordement (1) (plages de soudure) destinées à contacter le circuit avec des raccordements de la platine-mère,
**caractérisé en ce que** les surfaces de raccordement (1) atteignent respectivement le bord inférieur (6) et **en ce qu'**il comporte un évidement (2), constituant un dépôt de métal d'apport de soudure (3), traversant le support de circuit (4), s'étendant à partir de la surface frontale inférieure (5) du support de circuit (4) vers le haut dans la surface de raccordement respective (1).

2. Circuit hybride selon la revendication 1,
**caractérisé en ce qu'**il comporte des bornes de raccordement longitudinales, dont une extrémité peut être reliée à un point de contact de la platine-mère et dont l'extrémité opposée est soudée sur une surface de raccordement (1) par l'intermédiaire d'une structure de serrage en forme de poche, entourant les bords inférieurs (6) du support de circuit (4).
